# EUROPEAN PATENT SPECIFICATION

(11) **EP 1 964 189 B1**
(45) Date of publication and mention of the grant of the patent: **18.08.2010**
(21) Application number: 06826181.7
(22) Date of filing: 12.10.2006
(51) Int. Cl.: H01L 51/50

(54) **COLOR TUNABLE LIGHT-EMITTING DEVICES AND METHOD OF MAKING THE SAME**
FARBABSTIMMBARE LICHTEMITTIERENDE ANORDNUNGEN UND HERSTELLUNGSVERFAHREN DAFÜR
DISPOSITIFS PHOTO-EMETTEURS ACCORDABLES EN COULEUR ET PROCEDE DE FABRICATION CORRESPONDANT

(30) Priority: 12.12.2005 US 299925
(43) Date of publication of application: 03.09.2008
(73) Proprietor: GENERAL ELECTRIC COMPANY, Schenectady, NY 12345 (US)
(72) Inventor: LIU, Jie, Niskayuna, NY 12309 (US)
(74) Representative: Bedford, Grant Richard
(86) International application number: PCT/US2006/040702
(87) International publication number: WO 2007/070162

(56) References cited:
- EP-A- 1 601 030
- WO-A-92/14234
- JP-A- 8 054 832
- US-A1- 2005 153 775

## Description

### STATEMENT REGARDING FEDERALLY SPONSORED RESEARCH & DEVELOPMENT

This invention was made with Government support under contract number 70NANB3H3030 awarded by NIST. The Government has certain rights in the invention.

### BACKGROUND

The invention relates generally to color tunable light-emitting devices. More particularly the invention relates to color tunable organic light-emitting devices. Organic light-emitting devices (OLEDs) have attracted extensive research and development efforts due to their potential applications for flat panel display and general illumination. Currently available devices or models are mainly focused on devices with a fixed color, either intrinsic color emitted by the OLEDs or an arbitrarily produced color by various color conversion teclmiques, such as by making a stack of red, and/or green, and/or blue light-emitting devices, using extra photoluminescent layers.

US 2005/153775 discloses a gaming apparatus comprising a light-emitting device that has two light-emitting elements with an electrochromic element between them.

However, for certain applications, such as interior/exterior decorations, and signage, improvements in color tunability are desirable. Thus, there is a need for color tunable light-emitting devices exhibiting enhanced control on the color of the light emerging from the device.

### BRIEF DESCRIPTION

In accordance with the aspects of the present invention, a color tunable light-emitting device is presented. In one embodiment the color tunable light-emitting device comprises a first light-emitting element, a second light-emitting element, an active light transformative element selected from the group consisting of electrochromic elements, photochromic elements, and thermochromic elements, said active light transformative element being disposed between said first light-emitting element and said second light-emitting element.

In one embodiment not forming part of the present invention the color tunable light-emitting device comprises a first light-emitting element, a second light-emitting element, an electrochromic element disposed between said first light-emitting element and said second light-emitting element; and at least one light transmissive element, wherein the first and second light-emitting elements emit light at different wavelengths.

In another embodiment, a color tunable light-emitting device comprises a first light-emitting element, a second light-emitting element, a photochromic element disposed between said first light-emitting element and said second light-emitting element; and at least one light transmissive element, wherein the first and second light-emitting elements emit light at different wavelengths.

In yet another embodiment, a color tunable light-emitting device comprises a first light-emitting element, a second light-emitting element, a thermochromic element disposed between said first light-emitting element and said second light-emitting element; and at least one light transmissive element, wherein the first and second light-emitting elements emit light at different wavelengths.

According to further aspects of the present invention, a method of fabricating a color tunable light-emitting device is presented.

### DRAWINGS

These and other features, aspects, and advantages of the present invention will become better understood when the following detailed description is read with reference to the accompanying drawings in which like characters represent like parts throughout the drawings, wherein:
FIG. 1 is a schematic representation of an exemplary embodiment of a color tunable light-emitting device, according to aspects of the present invention;
FIG. 2 is a cross-sectional representation of an exemplary embodiment of a color tunable light-emitting device, according to aspects of the present invention;
FIG. 3 is a cross-sectional representation of an exemplary embodiment of a color tunable light-emitting device, according to aspects of the present invention;
FIG. 4 is a cross-sectional representation of an exemplary embodiment of a color tunable light-emitting device, according to aspects of the present invention;
FIG. 5 is a cross-sectional representation of an exemplary embodiment of a color tunable light-emitting device, according to aspects of the present invention;
FIG. 6 is a representation of exemplary OLED structures;
FIG. 7 is a flow chart illustrating an exemplary process of fabricating the color tunable light-emitting device according to aspects of the present invention;
FIG. 8 is a representation of the change in color emitted from a color tunable light-emitting device at different temperatures; and
FIG. 9 is a schematic representation of exemplary electrochromic elements.

In the following specification and the claims, which follow, reference will be made to a number of terms, which shall be defined to have the following meanings. The singular forms "a", "an" and "the" include plural referents unless the context clearly dictates otherwise.

As used herein, the term "disposed over" or "deposited over" or "disposed between" refers to disposed or deposited immediately on top of and in contact with, or disposed or deposited on top of but with intervening layers there between.

The term "alkyl" as used in the various embodiments of the present invention is intended to designate linear alkyl, branched alkyl, aralkyl, cycloalkyl, bicycloalkyl, tricycloalkyl and polycycloalkyl radicals comprising carbon and hydrogen atoms, and optionally containing atoms in addition to carbon and hydrogen, for example atoms selected from Groups 15, 16 and 17 of the Periodic Table. Alkyl groups may be saturated or unsaturated, and may comprise, for example, vinyl or allyl. The term "alkyl" also encompasses that alkyl portion of alkoxide groups. Unless otherwise noted, in various embodiments normal and branched alkyl radicals are those containing from 1 to about 32 carbon atoms, and comprise as illustrative non-limiting examples C₁-C₃₂ alkyl (optionally substituted with one or more groups selected from C₁-C₃₂ alkyl, C₃-C₁₅ cycloalkyl or aryl); and C₃-C₁₅ cycloalkyl optionally substituted with one or more groups selected from C₁-C₃₂ alkyl or aryl. Some illustrative, non-limiting examples comprise methyl, ethyl, n-propyl, isopropyl, n-butyl, sec-butyl, tertiary-butyl, pentyl, neopentyl, hexyl, heptyl, octyl, nonyl, decyl, undecyl and dodecyl. Some particular illustrative non-limiting examples of cycloalkyl and bicycloalkyl radicals comprise cyclobutyl, cyclopentyl, cyclohexyl, methylcyclohexyl, cycloheptyl, bicycloheptyl and adamantyl. In various embodiments aralkyl radicals comprise those containing from 7 to about 14 carbon atoms; these include, but are not limited to, benzyl, phenylbutyl, phenylpropyl, and phenylethyl. The term "aryl" as used in the various embodiments of the present invention is intended to designate substituted or unsubstituted aryl radicals comprising from 6 to 20 ring carbon atoms. Some illustrative non-limiting examples of aryl radicals include C₆-C₂₀ aryl optionally substituted with one or more groups selected from C₁-C₃₂ alkyl, C₃-C₁₅ cycloalkyl, aryl, and functional groups comprising atoms selected from Groups 15, 16 and 17 of the Periodic Table. Some particular illustrative, non-limiting examples of aryl radicals comprise substituted or unsubstituted phenyl, biphenyl, tolyl, xylyl, naphthyl and binaphthyl.

As used herein the term "substantially transparent" means allowing at least 50 percent, of light in the visible wavelength range to be transmitted through an article or component, typically a film having a thickness of about 0.5 micrometer or less, at an incident angle of less than or equal to 10 degrees.

In accordance with certain embodiments of the present invention there is provided a color tunable light-emitting device. In one embodiment the color tunable light-emitting device comprises a first light-emitting element, a second light-emitting element, an active light transformative element comprising a photochromic element, a thermochromic element or a combination of the foregoing, disposed between said first light-emitting element and said second light-emitting element; and at least one light transmissive element, wherein the first and second light-emitting elements emit light at different wavelengths.

As used herein, electrochromic elements, photochromic elements, and thermochromic elements present in various embodiments of the color-tunable light-emitting devices of the present invention are defined to be "active" light transformative elements and are distinct from passive light transformative elements such as phosphors and color filters. Active light transformative elements modulate light passing through them in response to and as a function of an applied bias. In the case of electrochromic elements, the bias results from the application of a voltage differential within the electrochromic element. In the case of photochromic elements, the bias results from the irradiation of the photochromic element with a source of light. In the case of a thermochromic element, the bias results from the application of heat to (or the removal of heat from) the thermochromic element. Those skilled in the art will appreciate that since in each case the bias may be applied to a lesser or greater extent (i.e. the bias is tunable), the color emerging from the active light transformative element is tunable thereby. In certain embodiments, the light emerging from the color tunable light-emitting devices of the present invention will be modulated by the application of a predetermined bias, for example a specific voltage differential applied to an electrochromic element within a color tunable light-emitting device. In other instances, the bias is provided by the environment. For example, in the case of a photochromic element, the color emerging from a color tunable light-emitting device may be modulated by intentional changes in the level of ambient light or by an unintended change in the level of ambient light. An example of an intended change in the level of ambient light that may be given is the change in the level of ambient light that occurs as a theater or aircraft cabin is intentionally darkened. An example of an unintended change in the level of ambient light that may be given is the change in the level of ambient light that occurs as a dark cloud obscures the sun, or for that matter the change in the level of ambient light occasioned by the setting of the sun, a change anticipated though not necessarily intended. Similarly, in case of the thermochromic element, the change in color can be a result of an intentional change in temperature or may be a response to an unintended change in temperature. Such color tunable light-emitting devices may be used as a temperature indicator, signaling by a change in color whether something in thermal contact with the thermochromic element of the color tunable light-emitting device is cold, warm, or hot. In one embodiment the color tunable light-emitting device of the present invention further comprises at least one passive light transformative element.

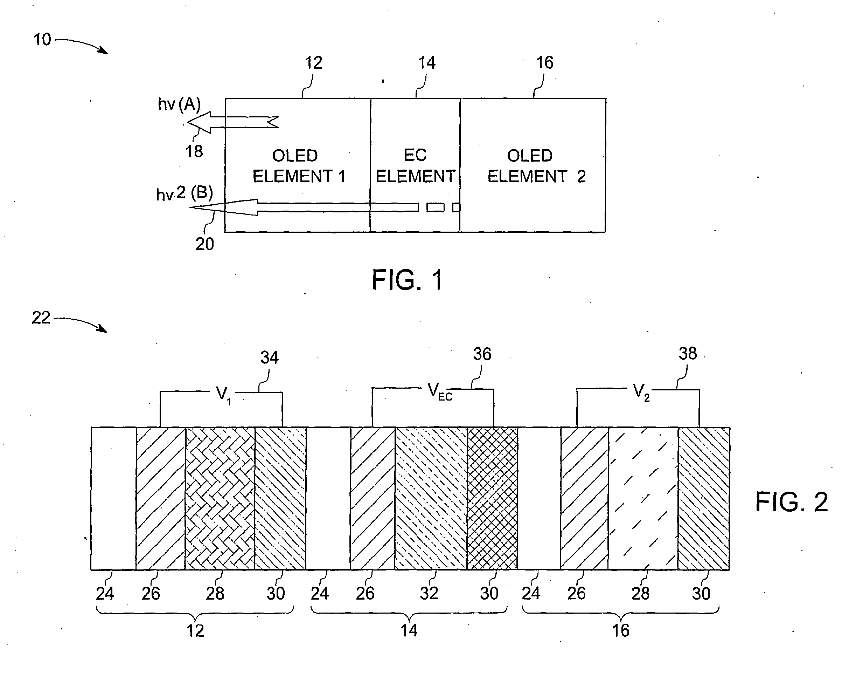

Referring to FIG. 1, the color tunable light-emitting device (10) comprises a first OLED (12) and a second OLED (16) emitting light at different wavelengths. In one embodiment the first OLED (12) may be a blue light-emitting OLED and the second OLED (16) may be a red light-emitting OLED. Alternately a different combination of OLEDs that emit light at different wavelengths may be used. For example the first OLED (12) may be a red light-emitting OLED and the second OLED (16) may be a blue light-emitting OLED. The transmission properties of the electrochromic element (14) can be tuned by varying an applied voltage bias. The perceived color of the light emerging from the device is thus a combination of the unmodulated light (18) emerging directly from the device and the modulated light (20), said modulated light being modulated by electrochromic element (14). In one embodiment the electrochromic element (14) is replaced with a photochromic element. When a photochromic element is used, the photochromic element can be tuned by coupling with a light tunable source. In another embodiment the electrochromic element (14) is replaced with a thermochromic element. When a thermochromic element is used the thermochromic element can be tuned by coupling with a temperature tunable source. In various embodiments, one or more components of the color tunable light-emitting device are advantageously substantially transparent.

FIG. 2 shows a cross-sectional view (22) of the color tunable light-emitting device (10) of FIG. 1. In this illustrated embodiment, the color tunable light-emitting device comprises a first OLED (12), the first OLED comprising a substrate (24), a first electrode (26), a first electroluminescent layer (28), and a second electrode (30); an electrochromic element (14), the electrochromic element comprising a second substrate (24), a third electrode (26), an electrochromophore layer (32), a fourth electrode (30); and a second OLED (16), the second OLED comprising a third substrate (24), a fifth electrode (26), a second electroluminescent layer (28) and a sixth electrode (30). The first OLED is separately connected to an external tunable voltage source (34), the electrochromic element is connected to external tunable voltage source (36) and the second OLED is also separately connected to an external tunable voltage source (38), indicating that the three elements discussed above i.e., the first OLED, electrochromic element and the second OLED are optically coupled but electrically isolated.

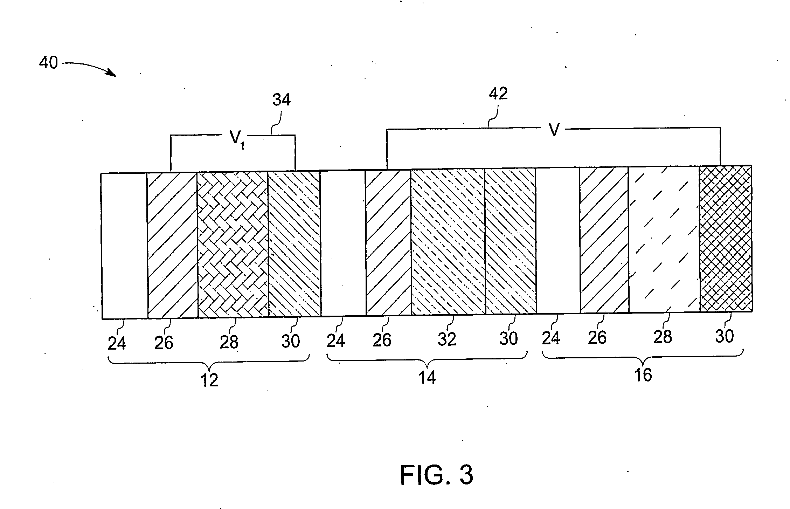

FIG. 3 shows a cross sectional view (40) of the color tunable light-emitting device (10) of FIG. 1 having an alternately configured power supply. As in FIG. 2, the light-emitting device illustrated by cross-sectional view (46) includes a first OLED (12), the first OLED comprising a first substrate (24), a first electrode (26), a first electroluminescent layer (28), and a second electrode (30); an electrochromic element (14), the electrochromic element comprising a second substrate (24), a third electrode (26), an electrochromophore layer (32), and a fourth electrode (30); and a second OLED (16); the second OLED comprising a third substrate (24), a fifth electrode (26), a second electroluminescent layer (28), and a sixth electrode (30). The first OLED is separately connected to an external tunable voltage source (34). The electrochromic element and the second OLED are connected to a single external tunable voltage source (42), indicating that two of the elements are electrically coupled, and all the three elements discussed above i.e., the first OLED, electrochromic element and the second OLED are optically coupled.

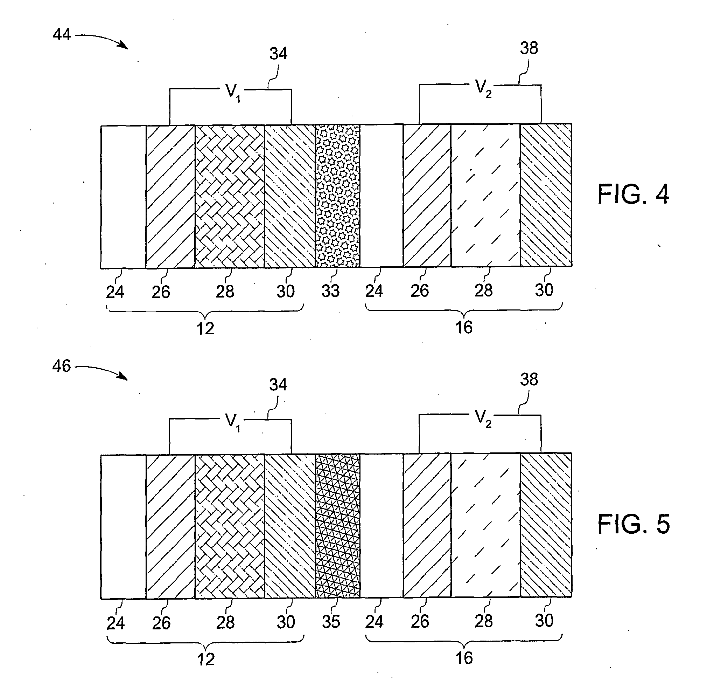

FIG. 4 illustrates an embodiment which is a color tunable light-emitting device (44) comprising a photochromic element (33).

FIG. 5 illustrates an embodiment which is a color tunable light-emitting device (46) comprising a thermochromic element (35).

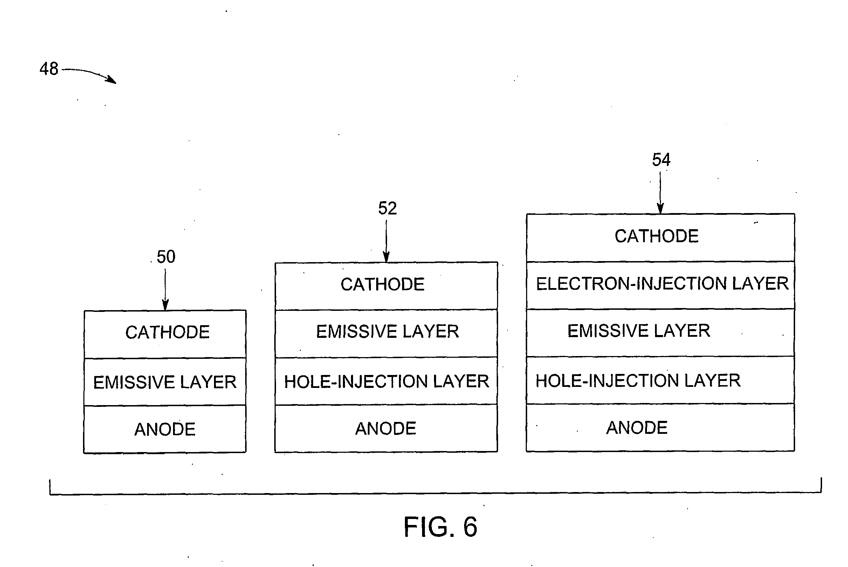

As noted, in one embodiment, the first light-emitting element and the second light-emitting element of the color tunable light-emitting device of the present invention are organic light emitting devices (OLEDs). Suitable OLEDs (48) for use in the present invention typically comprise an electroluminescent layer (hereinafter also referred to as an organic emissive layer or light-emitting layer) sandwiched between two electrodes (the anode and the cathode) for example as shown in FIG. 6 in each of the exemplary OLEDs (50), (52) and (54). Furthermore, the electroluminescent layer can be configured in a variety of ways as for example, (a) a single layer configuration (50) wherein the single layer organic semiconductor provides efficient hole injection/transport, emission, electron injection/transport functions; (b) a bilayer configuration (52) wherein a separate layer, in addition to the emitting layer, serves as a hole-injection (or electron-injection) layer; and (c) a trilayer configuration (54) wherein the device comprises a separate hole-injection layer and a separate electron-injection layer, in addition to the emissive layer. Furthermore, it should be noted that for each configuration, one or more additional layers may be present to provide, for example, charge blocking or confinement functions, if needed.

The anode represented in the various figures as the electrode (26) usually comprises a material having a high work function; e.g., greater than about 4.0 eV, for example from about 5 eV to about 7 eV. Transparent metal oxides, such as indium tin oxide ("ITO"), are typically used for this purpose. ITO is substantially transparent to light transmission and allows light emitted from organic emissive layer easily to escape through the ITO anode layer without being seriously attenuated. Other materials suitable for use as the anode layer are tin oxide, indium oxide, zinc oxide, indium zinc oxide, zinc indium tin oxide, antimony oxide, and mixtures thereof. The anode layer may be deposited on the underlying element by a variety of techniques including physical vapor deposition, chemical vapor deposition, and sputtering. The thickness of an anode comprising such an electrically conducting oxide is typically in the range from about 10 nanometers (nm) to about 500 nm, specifically from about 10 nm to about 200 nm, and more specifically from about 50 nm to about 200 nm. In certain embodiments, a thin, substantially transparent layer of a metal is also suitable; for example, a layer of a metal having a thickness less than about 50 nm, specifically less than about 20 nm. Suitable metals for the anode include, for example, silver, copper, tungsten, nickel, cobalt, iron, selenium, germanium, gold, platinum, aluminum, or mixtures thereof or alloys thereof.

The cathode represented in the various figures as the electrode (30) injects negative charge carriers (electrons) into the organic emissive layer and is typically made of a material having a low work function; e.g., less than about 4 eV. Those skilled in the art will appreciate, however, that not every material suitable for use as the cathode need have a low work function. Materials suitable for use as the cathode include K, Li, Na, Mg, Ca, Sr, Ba, Al, Ag, In, Sn, Zn, Zr, Sc, Y, elements of the lanthanide series, alloys thereof, or mixtures thereof. Suitable alloy materials for the manufacture of cathode layer are Ag-Mg, Al-Li, In-Mg, and Al-Ca alloys. Layered non-alloy structures are also possible, such as a thin layer of a metal such as Ca (thickness from about 1 to about 50 nm) or a non-metal such as LiF, KF, or NaF, over-capped by a thicker layer of some other metal, such as aluminum or silver. The cathode may be deposited on the underlying layer by, for example, physical vapor deposition, chemical vapor deposition, or sputtering. Depending on the application, the cathode can be transparent/ semitransparent (such as ITO, a thin layer of metal over-capped with ITO), or opaque (such as thick metal layers).

Electroluminiscent (EL) materials generally refer to organic fluorescent and/or phosphorescent materials, which emit light when subjected to an applied voltage bias. Electroluminiscent materials may be tailored to emit light in the desired wavelength range. The thickness of the electroluminiscent layer is preferably kept in the range of about 40 nm to about 300 nm. The electroluminiscent material may be a polymer, a copolymer, a mixture of polymers, or a lower molecular weight organic molecule having unsaturated bonds. Numerous electroluminescent materials are disclosed in "Advanced Materials 2000 12 (23) 1737-1750". Non-limiting examples of electroluminescent materials which may be used include poly(N-vinylcarbazole) (PVK) and its derivatives; polyfluorene and its derivatives such as poly(alkylfluorene), for example poly(9,9-dihexylfluorene), poly(dioctylfluorene) or poly(9,9-bis(3,6-dioxaheptyl)-fluorene-2,7-diyl), poly(para-phenylene) (PPP) and its derivatives such as poly(2-decyloxy-1,4-phenylene) or poly(2,5-diheptyl-1,4-phenylene); poly(p-phenylene vinylene) (PPV) and its derivatives such as dialkoxy-substituted PPV and cyano-substituted PPV; polythiophene and its derivatives such as poly(3-alkylthiophene), poly(4,4'-dialkyl-2,2'-bithiophene), poly(2,5-thienylene vinylene); poly(pyridine vinylene) and its derivatives; polyquinoxaline and its derivatives; and polyquinoline and its derivatives. In one particular embodiment, a suitable electroluminescent material is poly(9,9-dioctylfluorenyl-2,7-diyl) end capped with N,N-bis(4-methylphenyl)-4-aniline. Mixtures of these polymers or copolymers based on one or more of these polymers and others may also be used.

As noted, another class of suitable materials used as electroluminescent materials are the polysilanes. Typically, polysilanes are linear polymers having a silicon-backbone substituted with a variety of alkyl and/or aryl side groups. Polysilanes are quasi one-dimensional materials with delocalized sigma-conjugated electrons along the polymer backbone. Examples of polysilanes comprise poly(di-n-butylsilane), poly(di-n-pentylsilane), poly(di-n-hexylsilane), poly(methylphenylsilane), and poly(bis(p-butylphenyl)silane).

Organic materials having weight average molecular weight less than, for example, about 5000 grams per mole comprising aromatic units are also applicable as electroluminiscent materials. An example of such materials is 1,3,5-tris(N-(4-diphenylaminophenyl) phenylamino)benzene, which emits light in the wavelength range of 380-500 nm. The organic EL layer also may be prepared from lower molecular weight organic molecules, such as phenylanthracene, tetraarylethene, coumarin, rubrene, tetraphenylbutadiene, anthracene, perylene, coronene, or their derivatives. These materials generally emit light having a maximum wavelength of about 520 nm. Still other suitable materials are the low molecular-weight metal organic complexes such as aluminum-, gallium-, and indium-acetylacetonate, which emit light in the wavelength range of 415-457 nm, aluminum-(picolymethylketone)-bis(2,6-di(t-butyl)phenoxide) or scandium-(4-methoxy-picolylmethylketone)-bis(acetylacetonate), which emit in the range of 420-433 nm. In certain white light applications, the preferred electroluminiscent materials are those that emit light in the blue-green wavelengths. Other suitable electroluminiscent materials that emit in the visible wavelength range are organo-metallic complexes of 8-hydroxyquinoline, such as tris(8-quinolinolato)aluminum and its derivatives. Other non-limiting examples of electroluminiscent materials are disclosed in U. Mitschke and P. Bauerle, "The Electroluminescence of Organic Materials, J. Mater. Chem., Vol. 10, pp. 1471-1507 (2000)".

As described above, the OLEDs may further include one or more layers such as a charge transport layer, hole transport layer, a hole injection layer, a hole injection enhancement layer an electron transport layer, an electron injection layer and an electron injection enhancement layer or any combination thereof. The OLEDs may further include a substrate layer such as, but not limited to, a polymeric substrate.

Materials suitable for use as charge transport layers typically include low-to-intermediate molecular weight organic polymers (for example, organic polymers having weight average molecular weights (M_{w}) of less than about 200,000 grams per mole) for example, poly(3,4-ethylenedioxythiophene) (PEDOT), polyaniline, poly(3,4-propylenedioxythiophene) (PProDOT), polystyrenesulfonate (PSS), polyvinyl carbazole (PVK), and like materials.

Examples of materials suitable for the hole transport layer include triaryldiamines, tetraphenyldiamines, aromatic tertiary amines, hydrazone derivatives, carbazole derivatives, triazole derivatives, imidazole derivatives, oxadiazole derivatives comprising an amino group, polythiophenes, and like materials. Suitable materials for a hole-blocking layer comprise poly(N-vinyl carbazole), and like materials.

Materials suitable for the hole-injection layer are known to those skilled in the art and include "p-doped" (proton-doped) conducting polymers, such as proton-doped polythiophene or polyaniline, and p-doped organic semiconductors, such as tetrafluorotetracyanoquinodimethane (F4-TCQN), doped organic and polymeric semiconductors, and triarylamine-containing compounds and polymers. Suitable electron-injection materials are also known to those skilled in the art and include polyfluorene and its derivatives, aluminium tris(8-hydroxyquinoline) (Alq3), organic/polymeric semiconductors n-doped with alkali (alkaline earth) metals, and the like.

Examples of materials suitable for the hole injection enhancement layer include arylene-based compounds such as 3,4,9,10-perylenetetra-carboxylic dianhydride, bis(1,2,5-thiadiazolo)-p-quinobis(1,3-dithiole), and like materials.

Examples of materials suitable for the electron injection enhancement layer materials and electron transport layer materials include metal organic complexes such as oxadiazole derivatives, perylene derivatives, pyridine derivatives, pyrimidine derivatives, quinoline derivatives, quinoxaline derivatives, diphenylquinone derivatives, nitro-substituted fluorene derivatives, and like materials.

Typically, the OLED comprises one or two substrates selected from rigid substrates and flexible substrates. The rigid substrates include but are not limited to glass, metal and plastic; and the flexible substrates include but are not limited to flexible glass, metal foil, and plastic films. Non-limiting examples of substrates include thermoplastic polymers (e.g. poly(ethylene terephthalate), poly(ethylene naphthalate), polyethersulfones, polycarbonates, polyimides, polyacrylates, polyolefins and the like), glass, metal, and combinations thereof. The light transmissive element, which forms a part of the color tunable light-emitting device is typically a separate substrate layer or a substrate comprised in an OLED, as described above.

As noted, passive light transformative elements employed in certain embodiments of the color tunable light-emitting devices of the present invention are illustrated by color filters and phosphors. A color filter is typically comprises a sheet of dyed glass, gelatin, or plastic which absorbs certain colors and permits better rendition of others. Color filters are well known to those skilled in the art.

Phosphors illustrate another type of passive light transformative element. A phosphor exhibits the phenomenon of phosphorescence. Phosphorescence may be defined as sustained light emission following an initial exposure to light. This is sometimes referred to as "glowing without further stimulus". Phosphors are well known to those skilled in the art and are typically transition metal compounds or rare earth compounds of various types. The term "transition metal" more commonly refers to any element in the d-block of the periodic table, including zinc and scandium. This corresponds to periodic table groups 3 to 12 inclusive. Compounds of the "inner transition elements" from the lanthanide and actinide series where the inner f orbital is filled as atomic number increases may also be used as the phosphor. The inner transition elements are made up of the elements from cerium (At. No. 58) to lutetium (At. No. 71) and thorium (At. No. 90) to Lawrencium (At. No. 103). Rare earth compounds are typically oxides of the elements in the lanthanide series that include actinium, thorium, protactinium, uranium, neptunium, plutonium, americium, curium, berkelium, californium, einsteinium, fermium, mendelevium, nobelium and lawrencium.

The color tunable light-emitting devices of the present invention may include additional layers such as, but not limited to, one or more of an abrasion resistant layer, an adhesion layer, a chemically resistant layer, a photoluminescent layer, a radiation-absorbing layer, a radiation reflective layer, a barrier layer, a planarizing layer, an optical diffusing layer, and combinations thereof.

Examples of suitable electrochromic materials are, inorganic metal oxides, most commonly transition metal oxides (e.g., WO₃, V₂O₅, and the like), electroconductive polymers, such as unsubstituted and substituted polyaniline, polythiophene and polypyrrole, and the like. Examples of suitable electrode materials for use in the electrochromic element are transparent metal oxides, such as ITO, fluorine doped SnO₂, and the like; semi-transparent thin metals (such as Au etc); and conducting polymers, such as poly(3,4-ethylenedioxythiophene)/polystyrene sulfonate (PEDOT/PSS), and like materials. In one embodiment, ion conductors and/or electrolytes may also be employed as components of the electrochromic element in the color tunable light-emitting device. Examples of suitable ion conductors and electrolytes include liquid electrolyte solutions, such as lithium perchlorate in propylene carbonate, and ionic liquids; gel electrolytes comprising a polymeric material (e.g., polyvinyl butyral, polyethylene oxide, polymethyl methacrylate, and polyethylene glycol), a lithium salt (e.g., LiClO₄, LiCF₃SO₃. LiCl, LiPF₆), and a solvent (e.g., propylene carbonate, acetonitrile, ethylene carbonate, and the like); and solid polymeric electrolytes (e.g., cured or crosslinked polyacrylates, polyurethanes, and the like).

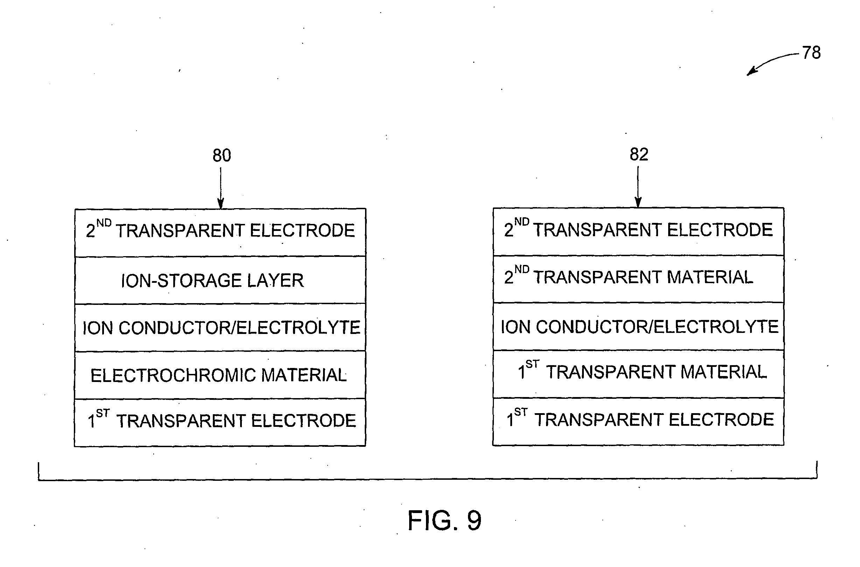

Electrochromic elements (78) are at times herein referred to as electrochromic devices, "ECDs". Exemplary ECD's are shown in FIG. 9. The ECDs may be "inorganic" ECDs or "organic" ECDs. Inorganic ECDs having the configuration 1 (80, FIG. 9) can be fabricated according to "C. Bechinger et al J. Appl. Phys. 80, pp1226, 1996" and "D.R. Rosseinsky et al., Advanced Materials, 13, pp 783-793, 2001". In particular, ITO is used as a bottom transparent electrode (1^{st} Transparent Electrode), onto which an electrochromic material (typically comprising a transition metal oxide, such as WO₃), an ion conductor layer (such as MgF₂, or an electrolyte), an ion-storage layer (such as V₂O₅) and a transparent top electrode (2^{nd} Transparent Electrode) (for example a thin metal layer, an ITO layer, or like material) are sequentially deposited. In one embodiment, the change in color and/or transmittance may be controlled by the choice of the electrochromic material employed.

Organic ECDs, having the configuration 2 (82, FIG. 9) can be fabricated according to "W. Lu, et al, Science, 297, pp 983-987, 2002" and "AA. Argun et al, Adv. Mater. 15, pp1338-1341, 2003". In a particular embodiment, ITO is used as the bottom transparent electrode, onto which a first organic electrochromic material (not shown in the figure) (such as polythiophene and its derivatives), an ion conductor layer (such as an electrolyte), a second complementary electrochromic material (not shown in the figure) (such as polyaniline), and another transparent top electrode (for example a thin metal layer, an ITO layer, or like material) are sequentially deposited. Alternatively, as disclosed in US Patent 5,124,832 and US Patent 6,136,161, the device assembly can be fabricated by lamination, i.e. forming the device assembly by laminating (1) a first component comprising a substrate, a first transparent conductor (for example an ITO layer, an F doped SnO₂ layer, or like material), a first polymeric electrochromic material (for example polythiophene), a preformed sheet of electrolyte, for example, a gel electrolyte (for example lithium triflate dispersed in a polymer matrix), and (2) a second component comprising a second electrochromic material, an inorganic ion-storage layer (such as TiO₂) and a substrate. The change in color and/or transmittance may be controlled by the choice of electrochromic material employed. For example, red, green, and blue electrochromic polymeric materials may be employed as disclosed by Sonmez et al "G. Sonmez et al, Adv. Mater., V16, pp1905, 2004"

Inorganic-organic hybrid ECDs, having the configuration 1 (80 FIG. 9), can be fabricated according to "H. Heuer, et al, Adv. Funct. Mater. V12, pp89-94, 2002". In particular, the device assembly is formed by joining (1) a first component comprising substrate, a first transparent electrode (for example an ITO layer, an F doped SnO₂ layer, or like material), a polymeric electrochromic material (for example polythiophene), and a gel electrolyte (for example lithium triflate dispersed in a polymer matrix), with (2) a second component comprising an inorganic ion-storage layer (such as TiO₂), a second transparent electrode, and a substrate. The change in color and/or transmittance may be controlled by the choice of the electrochromic material employed.

Photochromic materials are well known in the art. Examples of suitable photochromic materials include asymmetric photochromic compounds as described in US Patent 6,936,725. A "photochromic protein" as described in US Patent 6,956,984 may also be employed as a photochromic element in the color tunable light-emitting device.

Pyran derivatives as described in US Patent 6,306,316 and German patent 198 20781, may be used as photochromic compounds in the photochromic element of the color tunable light-emitting devices of the instant invention. Specific examples of the pyran derivatives include 3-(4-diphenylaminophenyl)-3-(2-fluorophenyl)-3H-naphtho[2,1-b]pyran, 3-(4-dimethylaminophenyl)-3-(2-fluorophenyl)-3H-naphtho[2,1-b]pyran, 3-(2-fluorophenyl)-3-[4-(N-morpholinyl)phenyl]-3H-naphtho[2,1-b]pyran, 3-(2-fluorophenyl)-3-[4-(N-piperidinyl)phenyl]-3H-naphtho[2,1-b]pyran, 3-(4-dimethylaminophenyl)-6-(N-morpholinyl)-3-phenyl-3H-naphtho[2,1-b]pyran, 6-(N-morpholinyl)-3-[4-(N-morpholinyl)phenyl]-3-phenyl-3H-naphtho[2,1-b]pyran, 6-(N-morpholinyl)-3-phenyl-3-[4-(N-piperidinyl)phenyl]-3H-naphtho[2,1-b]pyran, and 6-(N-morpholinyl)-3-phenyl-3-[4-(N-pyrrolidinyl)phenyl]-3H-naphtho[2,1-b]pyran, and mixtures of two or more of the foregoing. Photochromic indeno[2,1-f]naphtho[1,2-b]pyrans disclosed in WO 99/15518, and spiro-9-fluoreno[1,2-b]pyrans, disclosed in German patent 19902771 may also serve as components of the photochromic element in the color tunable light-emitting devices of the present invention.

In one embodiment, the photochromic element used in the color tunable light-emitting device of the present invention comprises a cured photochromic polymerizable composition, for example a composition as described in US Patent 6,362,248.

In one embodiment, photochromic 2H-naphtho[1,2-b]pyran compounds that impart grey color, as described in US Patent 6,387,512 may be used in preparing the photochromic element. In an alternate embodiment, one or more of the spiropyran salt compounds disclosed in US Patent 5,708,181 may serve as a component of the photochromic element. Other classes of compounds which may serve as a component of the photochromic are exemplified by azobenzene compounds, thioindigo compounds, dithizone metal complexes, spiropyran compounds, spirooxazine compounds, fulgide compounds, dihydropyrene compounds, spirothiopyran compounds, 1,4-2H-oxazine compounds, triphenylmethane compounds, viologen compounds, naphthopyran compounds, and benzopyran compounds.

A variety of techniques for fabricating photochromic elements are known to those skilled in the art. In one embodiment, the photochromic element is fabricated in a manner as described in US Patent 6,476,103.

In one embodiment, the photochromic substance is used without additional adjuvants. In an alternate embodiment of the present invention, the color changing function and/or the fastness to light may be enhanced by combining the photchromic substance with an adjuvant (also referred to herein as an auxiliary agent) such as one or more high-boiling solvents, plasticizers, synthetic resins, hindered amines, hindered phenols, and the like. These compounds are well known additives for use in combination with photochromic substances and their proportions can be selected from the known ranges. Suitable examples of hindered phenol compounds include, among others, 2,6-di-t-butylphenol, 2,4,6-tri-t-butylphenol, 2,6-di-t-butyl-p-cresol, 4-hydroxymethyl-2,6-di-t-butylphenol, 2,5-di-t-butylhydroquinone, 2,2'-methylene-(4-ethyl-6-t-butylphenol), 4,4'-butylidene-bis(3-methyl-6-t-butylphenol), and so on. Suitable examples of the hindered amine compounds include, among others, bis(2,2,6,6-tetramethyl-4-piperidinyl)sebacate, bis(1,2,2,6,6-pentamethyl-4-piperidinyl)sebacate, the polycondensate of dimethyl succinate and 1-(2-hydroxyethyl)-4-hydroxy-2,2,6,6-tetramethylpiperidine, bis(1,2,2,6,6-pentamethyl-4-piperidinyl)-2-(3,5-di-t-butyl-4-hydroxybenzyl)-2-n-butylmalonate, 1-[2-(3-(3,5-di-t-butyl-4-hydroxyphenyl)propionyloxy) ethyl]-4-(3-(3,5-di-t-butyl-4-hydroxyphenyl)propionyloxy)-2,2,6,6-tetramethylpiperidine, 8-benzyl-7,7,9,9-tetramethyl-3-octyl-1,3,8-triazaspiro[4.5]undecane-2,4-di one, tetrakis(2,2,6,6-tetramethyl-4-piperidine)butane carbonate, and Mark LA57, Mark LA62 and Mark LA67 (all the trademarks of Adeka-Argus Chemical Co., Ltd.) which are disclosed in Japanese Unexamined Patent Publication No. 252496/1987.

A wide variety of thermochromic materials known in the art can be used in the thermochromic element in the present invention. Exemplary thermochromic materials containing an acid-responsive chromogenic substance and an acidic substance as disclosed in US Patent 5,431,697 may be used. Acid-responsive chromogenic substances include triphenylmethanephthalide compounds, phthalide compounds, phthalan compounds, acyl-leucomethylene blue compounds, fluoran compounds, triphenylmethane compounds, diphenylmethane compounds, spiropyran compounds, and the like. Suitable specific acid-responsive chromogeneic substances include, but are not limited to, 3,6-dimethoxyfluoran, 3,6-dibutoxyfluoran, 3-diethylamino-6,8-dimethylfluoran, 3-chloro-6-phenylaminofluoran, 3-diethylamino-6-methyl-7-chlorofluoran, 3-diethylamino-7,8-benzofluoran, 2-anilino-3-methyl-6-diethylaminofluoran, 3,3',3 "-tris(p-dimethylaminophenyl)phthalide, 3,3'-bis(p-dimethylaminophenyl)phthalide, 3-diethylamino-7-phenylaminofluoran, 3,3-bis(p-diethylaminophenyl)-6-dimethylaminophthalide, 3-(4-diethylaminophenyl)-3-(1-ethyl-2-methylindol-3-yl)phthalide, 3-(4-diethylamino-2-methyl)phenyl-3-(1,2-dimethylindol-3-yl)phthalide, and 2'-(2-chloroanilino)-6'-dibutylaminospiro-(phthalido-3,9'-xanthene). Suitable acidic substances include 1,2,3-benzotriazole compounds, phenol compounds, thiourea compounds, oxo-aromatic carboxylic acids, and the like. Specific examples of acidic compounds include 5-butylbenzotriazole, bisbenzotriazole-5-methane, phenol, nonylphenol, bisphenol A, bisphenol F, 2,2'-biphenol, beta-naphthol, 1,5-dihydroxynaphthalene, alkyl p-hydroxybenzoates, phenol resin oligomer, and the like. The thermochromic materials may preferably be used with a solvent. The use of a solvent renders the material responsive to change in temperature with greater sensitivity and definition. Suitable solvents include alcohols, alcohol-acrylonitrile adducts, azomethine compounds, esters, and the like. Among specific examples of the solvent are decyl alcohol, lauryl alcohol, myristyl alcohol, cetyl alcohol, stearyl alcohol, behenyl alcohol, lauryl alcohol-acrylonitrile adduct, myristyl alcohol-acrylonitrile adduct, stearyl alcohol-acrylonitrile adduct, benzylidene-p-toluidine, benzylidene-butylamine, octyl caprate, decyl caprate, myristyl caprylate, decyl laurate, lauryl laurate, myristyl laurate, decyl myristate, lauryl myristate, cetyl myristate, lauryl palmitate, cetyl palmitate, stearyl palmitate, cetyl p-t-butylbenzoate, stearyl 4-methoxybenzoate, dilauryl thiodipropionate, dimyristyl thiodipropionate, stearyl benzoate, benzyl stearate, dibenzyl thiodipropionate, distearyl thiodipropionate, benzyl benzoate, and glycerol trilaurate. It should be understood that the term "thermochromic material" is used herein to mean any and all thermochromic materials including pseudo-thermochromic materials, which show a hysteresis of thermochromism.

Intrinsically thermochromic materials as disclosed in US Patent 5,426,143 may also be used in the thermochromic element in the color tunable light-emitting device. Intrinsically thermochromic materials comprise chromophores which are chemically altered on heating without the need for an external reagent, and which change color in the process. Thermochromic colors including Fast Yellow Gold Orange, Vermillion, Brilliant Rose, Pink, Magenta, Fast Blue, Artic Blue, Brilliant Green, Fast Black, Green Brown and mixtures of the foregoing, as disclosed in US Patent 6,929,136 may be used in the thermochromic element. Rylene dyes as disclosed in US Patent 6,486,319 may also be employed in the thermochromic element. Another exemplary thennochromic material as disclosed in US Patent 4,138,357 comprises a substantially colorless electron donating color-former capable of forming color upon reacting with an electron accepting acid compound and an aromatic hydroxy ester. As disclosed in US Patent 4,028,118 a thermochromic material exhibiting a sharp and reversible metachromation at temperatures within a range of from -40°C to 80°C, formed from an electron donating chromatic organic compound, a compound containing a phenolic hydroxyl group, a compound selected from the group consisting of higher aliphatic monovalent alcohols and a compound selected from the group consisting of higher aliphatic monovalent acid alcohol esters can also be used as the thermochromic element in the color tunable light-emitting device.

Reversible thermochromic pigments that change color in the presence of diaminoalkane activators as disclosed in US Patent 5,480,482 may also be used as the thermochromic element of the present invention. Suitable dyes that can be employed in making the pigments include but are not limited to 6-(dimethylamino)-3,3-bis(dimethylaminophenyl)-1-(3H)isobenzofuranone (crystal violet lactone); 2'-anilino-6-diethylamino-3-methylfluoran; 2'-dibenzylamino-6'-diethylaminofluoran; 3,3-bis-(1-butyl-2-methyl-1-H-indol-3-yl)-1(3H)-isobenzofuranone; 3-(4-dimethylaminophenyl)-3-[N,N'-bis(4-octylphenyl)amino)phthalide; 2,4,8,10-tetraiodo-3,9-dihydroxy-6-(3',4',5',6'-tetrachlorophenyl-2-phthalido)xanthenone (Rose Bengal lactone); 3,3-bis(4'-hydroxy-3'-methyl-5'-dicarboxymethylaminomethyl)phenyliosbenzofuran-3-one (o-cresolphthalein complexone); 3,3-bis(sodium-3'-sulfonato-4'-hydroxyphenyl)-4,5,6,7-tetrabromoisobenzofuran-3-one (sulfobromonaphthalein sodium salt); 3,3-bis(3',5'-dibromo-4-hydroxyphenyl)isobenzofuran-3-one (tetrabromophenolphthalein bromocresol green thymolphthalein. These pigments may be used in thermochromic elements capable of modulating an exceptionally wide range of color inputs, thereby providing even greater color control of the light output from the color-tunable light emitting devices of the present invention.

Other reversible thermochromic materials as disclosed in US Patent 5,281,570 comprising an electron donor color-former; a sulfide, sulfoxide or sulfone containing a hydroxy phenyl group; and a chemical compound selected from alcohols, esters, ethers, ketones, carboxylic acids or acid amides, that chromatizes very brightly and in a dense color, generating a change of chromic hue (colored - colorless) within a narrow temperature range and providing a stable thermochromatism on a long term basis can also be employed in the thermochromic element. Alternately a reversible thermochromic composition as provided in US Patent 6,048,387 containing a diazarhodamine lactone derivative as an electron-donating color-developing organic compound, an electron-accepting compound, and a reaction medium for causing a reversible electron exchange reaction between the components in a specified temperature range may be used. This reversible thermochromic composition develops clear reddish color in its colored state, and becomes colorless in its colorless state, and is remarkably free of residual color. Still other reversible thermochromic compounds include bridged phthalides and sulfinate esters as disclosed in US Patent 5,294,375.

Additional thermochromic compositions known in the art can also be employed in the thermochromic element of the color tunable light-emitting devices of the present invention. In one instance, the thermochromic composition comprises an electron donating chromogeneic organic compound, an electron accepting compound and at least one desensitizer selected from among diphenylamine derivatives as disclosed in US Patent 5,350,634 and at least one desensitizer selected from among carbazole derivatives as disclosed in US Patent 5,350,633. Another example of a thermochromic composition as disclosed in US Patent 4,743,398 comprises a colorant in a binder and an activator that causes the thermochromic colorant to change color at a temperature lower than the temperature at which the colorant would undergo a color change in the absence of the activator. In one specific example, the thermochromic colorant is folic acid and the activator is an acid that has a pK of less that 4.2. Yet another suitable thermochromic composition is disclosed in US Patent 4,717,710 which provides a thermochromic composition comprising an electron-donating chromogeneic material, a 1,2,3-triazole compound, a weakly basic, sparingly soluble azomethine or carboxylic acid salt, and an alcohol, amide or ester solvent. Other examples of thermochromic compositions include combinations of at least one color-former and at least one Lewis acid in a polymer mixture as disclosed in US Patent 6,908,505. Such compositions reversibly change appearance from substantially transparent to substantially non-transparent above a lower critical solution temperature. Another exemplary composition is disclosed in US Patent 4,620,941 and comprises at least one electron-donating organic chromogenic compound, at least one compound serving as a color developing material and selected from thiourea and derivatives thereof, guanidine and derivatives thereof, benzothiazole, and benxothiazolyl derivatives, and at least one compound serving as a desensitizer selected from the group consisting of alcohols, esters, ketones, ethers, acid amides, carboxylic acids, and hydrocarbons.

The reflective elements that can be employed in certain embodiments include but are not limited to mirrors and aluminium film. Mirrors typically include highly reflective metallic foils, or a metal film on a glass or a plastic substrate.

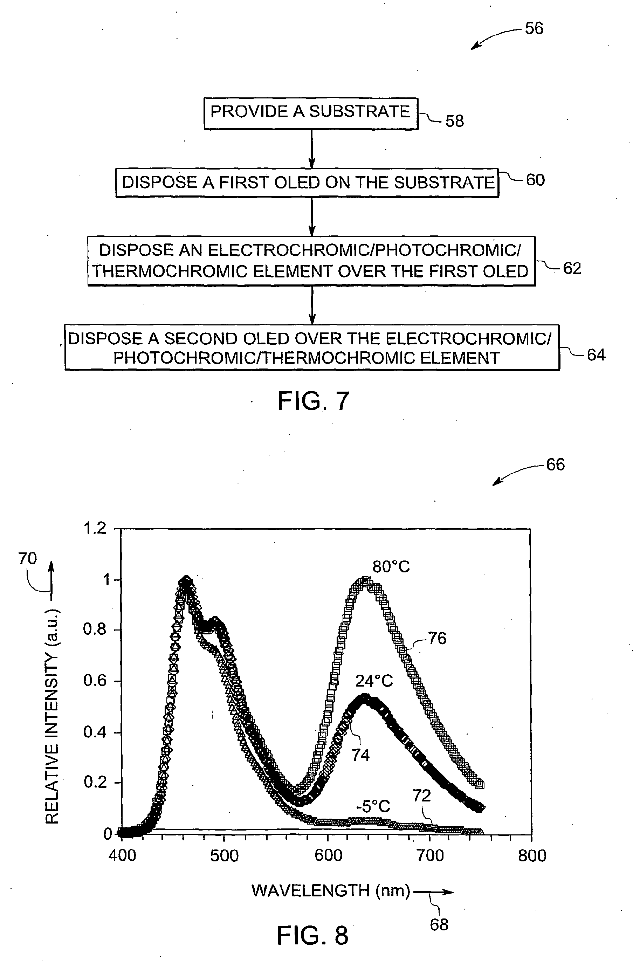

FIG. 7 is a flow chart illustrating an exemplary process (56) of fabricating a color tunable light-emitting device according to aspects of the present invention. Process (56) begins with step (58) providing a substrate, which is, in one embodiment, a glass substrate. (In the discussion of FIG. 7, FIG. 2 serves as a useful point of reference. In FIG. 2 the first OLED is pictured as comprising elements (24) (a first substrate), (26) (a first electrode), (28) (a first electroluminescent layer), and (30) (a second electrode)). In the next step, (60), a first OLED is disposed upon the substrate. In a following step (62), an active light transformative element (e.g. an electrochromic element, a photochromic element, or a thermochromic element) is disposed on the first OLED (see FIG. 2). In a following step (64), a second OLED is disposed over the active light transformative element (see FIG. 2).

Depositing or disposing the various layers comprising the color-tunable light-emitting devices of the present invention may be carried out using known techniques such as spin coating, dip coating, reverse roll coating, wire-wound or Mayer rod coating, direct and offset gravure coating, slot die coating, blade coating, hot melt coating, curtain coating, knife over roll coating, extrusion, air knife coating, spray, rotary screen coating, multilayer slide coating, coextrusion, meniscus coating, comma and microgravure coating, lithographic processes, langmuir processes, flash evaporation, vapor deposition, plasma-enhanced chemical-vapor deposition ("PECVD"), radiofrequency plasma-enhanced chemical-vapor deposition ("RFPECVD"), expanding thermal-plasma chemical-vapor deposition ("ETPCVD"), electron-cyclotron-resonance plasma-enhanced chemical-vapor deposition (ECRPECVD"), inductively coupled plasma-enhanced chemical-vapor deposition ("ICPECVD"), sputtering techniques (including, reactive sputtering), like techniques, and combinations thereof. Without further elaboration, it is believed that one skilled in the art can, using the description herein, utilize the present invention to its fullest extent. The following examples are included to provide additional guidance to those skilled in the art in practicing the claimed invention. The examples provided are merely representative of the work that contributes to the teaching of the present application. Accordingly, these examples are not intended to limit the invention, as defined in the appended claims, in any manner.

### EXAMPLES

### EXAMPLE 1 : A color tunable light-emitting device was fabricated as follows.

### Step 1: Preparation of a Red-Color Organic Light-Emitting Device

Glass pre-coated with indium tin oxide (ITO) (Applied Films) was used as the substrate. A layer (ca. 65 nanometers (nm)) of poly (3,4-ethylendioxythiophene/polystyrene sulfonate (PEDOT:PSS) (*Bayer Corporation*), was deposited onto ultraviolet-ozone treated ITO substrates via spin-coating and then baked for 1 hour at 180°C in air. A layer (ca. 70 nm) of a red light-emitting polymer (LEP) (RP145 obtained from Dow Chemical) was then spin-coated atop the PEDOT layer. Then the samples were transferred to an argon filled glovebox nominally containing less than 1 ppm of oxygen and moisture. Next, a NaF (4nm)/A1 (100nm) bilayer cathode was thermally evaporated at a base vacuum of 2 x10⁻⁶ torr on top of the LEP layer. The device was then encapsulated using a glass slide sealed with a degassed optically clear adhesive (NORLAND OPTICAL ADHESIVE 68, obtained from Norland Products, Cranbury, New Jersey, USA.). The active light emitting-area was about 0.2cm².

### Step 2: Preparation of a Blue-Color Semitransparent Organic Light-Emitting Device

Glass pre-coated with ITO was used as the substrate. A layer (ca. 65nm) of PEDOT:PSS was deposited onto ultraviolet-ozone treated ITO substrates via spin-coating and then baked for 1 hour at 180°C in air. A layer (ca. 65nm) of a blue LEP (BP105 obtained from Dow Chemical) was then spin-coated atop the PEDOT:PSS layer. Then the samples were transferred to an argon filled glovebox nominally comprising less than 1 parts per million (ppm) of oxygen and moisture. Next, a Ca (5nm)/Au (25nm) bilayer cathode was thermally evaporated at a base vacuum of 2 x10⁻⁶ torr on top of the LEP layer. The Ca/Au bilayer was semitransparent in the visible light range. The device was then encapsulated using a glass slide sealed with the Norland Optical Adhesive 68). The active emitting-area was about 0.2cm².

### Step 3: Preparation of a Temperature Responsive Component

A commercially available product, a Gerber Fun Grips® Spill-Proof Color Changing Cup was used as the source of the thermochromic element used in this experiment. A detailed description of the cup can be found in US patent 6,513,379. The cup expressed a light-blue color at room temperature (about 24°C) and dark pinkish color at lower temperatures (about -5°C). In addition, the change in color is reversible. The cup, as purchased, was cut to into ½" x ½" plates with a pair of scissors, and the plates were used as the thermochromic element without additional modification.

### Step 4: Preparation Of a Color Tunable Light-Emitting Device Comprising a Thermochromic Element

A thermochromic element prepared in Step 3 was sandwiched between the red OLED prepared in Step 1 above and the blue OLED prepared in Step 2 above. Care was taken to ensure that the active emitting-areas of the OLEDs overlapped. The assembly was aligned such that the final perceived color consisted of two components: 1) a portion of the blue light emitted from the blue OLED, and 2) a portion of the red light produced by the red OLED traveling through the thermochromic element as well as the semi-transparent blue OLED. The edges of the assembly were then sealed with the Norland adhesive to provide mechanical integrity.

Test results using the color-tunable light-emitting device prepared in from Example 1 demonstrated that the thermochromic element modulated the amount of red light produced by the device since the final perceived color emerging from the color-tunable light-emitting device was shown to be temperature dependent. Thus, emission spectra of the color-tunable light-emitting device were measured at -5°C, 24°C and 80°C. A five-minute dwell time at each temperature condition was applied prior to the measurements at each temperature. Emission spectra measured at different temperatures are shown in FIG. 8 (66) and the values obtained were plotted in a graph with wavelength (68) as the X-axis and relative intensity (70) as the y-axis. Note that each spectrum was normalized to its peak intensity. At -5°C (See curve (72)), the thermochromic element was highly absorptive to the red light, thus the final perceived color was dominated by the blue component, thus resulting in the perception of a blue color. At 24°C (See curve (74)), the thermochromic element was relatively less absorptive to red light, and the final perceived light had more of the red component, thus resulting in the perception of a white color. At 80°C (See curve (76)), the emission spectrum comprised comparable levels of the red and blue components, and the final perceived color was a purplish-white color. In addition, the color changes, which resulted from the change in temperatures, were fully reversible.

### (PROPHETIC) EXAMPLE 2

As described in Example 1 above a blue light-emitting OLED and a red light-emitting OLED are prepared. An electrochromic element is prepared following the procedure of Step 1 of Example 1 but replacing the LEP with an electrochromic material, heptyl viologen bromide. The electrochromic element is then sandwiched between the two OLEDs, and encapsulated using a glass slide sealed with Norland Optical Adhesive 68 as described in Example 1, provision having been made for the two OLEDs and the electrochemical elements to be connected to three independently operable power sources as shown in FIG. 2. The final perceived color emerging from the color-tunable light-emitting device is found to be tunable by varying the voltage bias applied to the electrochromic element.

While only certain features of the invention have been illustrated and described herein, many modifications and changes will occur to those skilled in the art.

## Claims

1. A color tunable light-emitting device (10) comprising:
i. a first light-emitting element (12);
ii. a second light-emitting element (16);
iii. at least one substrate (24) comprising a light transmissive element,
wherein the first and second light-emitting elements (12,16) emit light at different wavelengths
**characterized by** further comprising an active light transformative element consisting of a photochromic element (33) or a thermochromic element (35), said active light transformative element being disposed between said first light-emitting element (12) and said second light-emitting element (16).

2. The color tunable light-emitting device according to claim 1, wherein at least one of the first and the second light-emitting elements (12,16) is at least partially transparent to visible light.

3. The color tunable light-emitting device according to claim 1, said device further comprising at least one passive light transformative element.

4. The color tunable light-emitting device according to claim 1, wherein at least one of the first and the second light-emitting element (12,16) is an organic light-emitting device, said organic light-emitting device comprising
a. a first electrode (26);
b. a second electrode (30);
c. an electroluminescent layer (28) disposed between the first electrode (26) and the second electrode (30);
wherein the first electrode (26) and the second electrode (30) are operably coupled to at least one tunable voltage source (34,38).

5. The color tunable light-emitting device according to claim 4, wherein the electroluminescent layer comprises an organic polymer.

6. The color tunable light-emitting device according to claim 1, including a thermochromic element (35) which comprises a thermochromic material contained in a base material.

## Patentansprüche

1. Farbabstimmbare lichtemittierende Vorrichtung (10), umfassend:
i. ein erstes Licht emittierendes Element (12),
ii. ein zweites Licht emittierendes Element (16),
iii. mindestens ein Substrat (24), das ein Licht übertragendes Element umfasst, wobei das erste und zweite Licht emittierende Element (12,16) bei verschiedenen Wellenlängen emittieren,
**dadurch gekennzeichnet, dass** sie weiter
ein aktives Licht transformierendes Element umfasst, das aus einem photochromen Element (33) oder einem thermochromen Element (35) besteht, wobei das aktive Licht transformierende Element zwischen dem ersten Licht emittierenden Element (12) und dem zweiten Licht emittierenden Element (16) angeordnet ist.

2. Farbabstimmbare Licht emittierende Vorrichtung nach Anspruch 1, worin mindestens eines des ersten und zweiten Licht emittierenden Elementes (12,16) zumindest teilweise für sichtbares Licht transparent ist.

3. Farbabstimmbare Licht emittierende Vorrichtung nach Anspruch 1, worin die Vorrichtung weiter mindestens ein passives Licht transformierendes Element umfasst.

4. Farbabstimmbare Licht emittierende Vorrichtung nach Anspruch 1, worin mindestens eines des ersten und zweiten Licht emittierenden Elementes (12,16) ein organisches Licht emittierendes Element ist, wobei das organische Licht emittierende Element umfasst
a. eine erste Elektrode (26),
b. eine zweite Elektrode (30),
c. eine elektrolumineszente Schicht (28), die zwischen der ersten Elektrode (26) und der zweiten Elektrode (30) angeordnet ist,
worin die erste Elektrode (26) und der zweite Elektrode (30) betriebsmäßig mit mindestens einer abstimmbaren Spannungsquelle (34, 38) gekoppelt sind.

5. Farbabstimmbare Licht emittierende Vorrichtung nach Anspruch 4, worin die elektrolumineszente Schicht ein organisches Polymer umfasst.

6. Farbabstimmbare Licht emittierende Vorrichtung nach Anspruch 1, die ein thermochromes Element (35) einschließt, das ein thermochromes Material umfasst, das in einem Basismaterial enthalten ist.

## Revendications

1. Dispositif luminescent (10) accordable en couleur, comprenant :
i. un premier élément luminescent (12) ;
ii. un second élément luminescent (16) ;
iii. au moins un substrat (24) constitué d'un élément phototransmetteur,
dans lequel les premier et second éléments luminescents (12, 16) émettent de la lumière à des longueurs d'ondes différentes
**caractérisé en ce qu'**il comprend en outre :
un élément phototransformateur actif consistant en un élément photochrome (33) ou un élément thermochrome (35), ledit élément thermochrome actif étant disposé entre ledit premier élément luminescent (12) et ledit second élément luminescent (16).

2. Dispositif luminescent accordable en couleur selon la revendication 1, dans lequel au moins un des premier et second éléments luminescents (12, 16) laisse au moins partiellement passer la lumière visible.

3. Dispositif luminescent accordable en couleur selon la revendication 1, ledit dispositif comprenant en outre au moins un élément phototransformateur passif.

4. Dispositif luminescent accordable en couleur selon la revendication 1, dans lequel au moins un des premier et second éléments luminescents (12, 16) est un élément luminescent organique, ledit dispositif luminescent organique comportant
a. une première électrode
b. une seconde électrode (30) ;
c. une couche électroluminescente (28) disposée entre la première électrode (26) et la seconde électrode (30) ;
la première électrode et la seconde électrode coopérant avec au moins une source de tension accordable (34, 38).

5. Dispositif luminescent accordable en couleur selon la revendication 4, dans lequel la couche électroluminescente est constituée d'un polymère organique.

6. Dispositif luminescent accordable en couleur selon la revendication 1, comprenant un élément thermochrome (35) composé d'une substance thermochrome contenue dans une matière de base.
